# EUROPEAN PATENT SPECIFICATION

(11) **EP 1 906 190 B1**
(45) Date of publication and mention of the grant of the patent: **07.01.2009**
(21) Application number: 05759364.2
(22) Date of filing: 13.06.2005
(51) Int. Cl.: G01R 15/14

(54) **CONTROL/PROTECTION DEVICE FOR ELECTRICAL DISTRIBUTION NETWORKS**
STEUER-/SCHUTZEINRICHTUNG FÜR ELEKTRISCHE VERTEILERNETZE
DISPOSITIF DE COMMANDE/DE PROTECTION POUR RESEAUX DE DISTRIBUTION ELECTRIQUE

(43) Date of publication of application: 02.04.2008
(73) Proprietor: ORMAZABAL PROTECTION & AUTOMATION, S.L., 48140 Igorre (Vizcaya) (ES)
(72) Inventor: BAROJA FERNANDEZ, Hugo, E-48140 IGORRE (Vizcaya) (ES); SANCHEZ RUIZ, Juan, Antonio, E-48140 IGORRE (Vizcaya) (ES); NUÑEZ GONZALEZ, Estibaliz, E-48140 IGORRE (Vizcaya) (ES)
(74) Representative: Carpintero Lopez, Francisco
(86) International application number: PCT/ES2005/000334
(87) International publication number: WO 2006/134178

(56) References cited:
- EP-A2- 0 851 442
- EP-A2- 0 917 157
- ES-A1- 2 174 754
- US-A- 4 074 193
- US-A- 5 432 438
- US-A1- 2002 180 459

## Description

### OBJECT OF THE INVENTION

The present invention has the object of the control/protection of power distribution grids, based on voltage and intensity capture means and on electronic control and protection devices integrated in the electrical equipment forming the power distribution grids.

The device has the object of providing voltage and intensity measuring functions, voltage presence/absence detection, fault passage detection, protection functions based on voltage and intensity measurement, control, automation, etc., as well as a communications function which, together with the digital inputs and outputs the device has, allows carrying out the control, protection and supervision of each of the electrical equipment of the installation incorporating it both locally and remotely.

### BACKGROUND OF THE INVENTION

The electrical equipment, boxes or switch gear, transformers, etc., used in operation and/or protection installations of transformation centers, distribution centers or substations, can incorporate electronic devices allowing function automation, the control and supervision of parameters or values, communication between equipment both locally and remotely, etc.

This allows performing supervision and control functions of the distribution grid which are increasingly more needed and required given the growing need for automation in distribution grids, as a result of a higher demand for supply quality.

For example, it is common for electrical equipment forming the distribution grid to incorporate electronic relays which can, for example, perform voltage presence and absence detection, overcurrent and fault or short circuit protection, intensity and voltage measurement, local control, automations, etc. In turn, in the event that the installation is automated, both for local and remote automation, each of these electronic relays can be connected to a data concentrator and equipment controller, which includes the possibility of recording the state of each of the electrical equipment integrated in the installation (data acquisition and supervision control system), programming performance or operation sequences, etc. Therefore, transformation or distribution centers can be equipped with different electronic relays, each of them complying with a certain function and the latter can in turn be included with a data concentrator and equipment controller for automation of the installation.

Each of these electronic relays can be assembled in a control rack independent of the corresponding electrical equipment or can be integrated in its own metal enclosure, together with the rest of the switch gear. The inclusion of the electronic equipment in the enclosure of each electrical equipment allows the assembly of the transformation or distribution center to be smaller, easy to install, to have better quality and field work is avoided.

The number of transformation or distribution centers is very high in a distribution grid, which involves a series of demands , such as standardization of installations so as to make their engineering, assembly, maintenance, future addons control, automation, etc., easier. One way of achieving this is to use integrated control and protection devices.

These control and protection devices consist of electronic equipment covering the protection, measurement, control and automatism functions of the different components or electrical equipment. These control and protection devices are formed by different functional modules, between which there is a module corresponding to the analog inputs, directly connected to high voltage transformers of intensity and of voltage measurement/protection.

Voltage transformers are occasionally installed in the base of the corresponding electrical equipment and their assembly is done on site. They are shielded plug-in transformers. Given their volume, they are not installed for every phase since the base of the switch gear lacks space for this purpose. Since they are installed, adjusted and checked on site, installation errors of the transformers may occur. These transformers can further be the cause of explosions giving rise to the destruction of the switch gear and its connections due to ferroresonance problems.

For the purpose of preventing the problems mentioned in the preceding paragraph, rather than using transformers for measuring voltage a capacitive voltage signal is used obtained through an electric field standardizing screen, provided in the connection bushings of the electrical equipment.

This capacitive voltage signal is commonly used for voltage presence/absence indicating or detection, and allows, as stated, obtaining voltage measurements, using to that end a measuring circuit which is arranged in parallel with the voltage presence indicating or detection device. Therefore, some designs make use of the accessible points in the voltage presence detection devices to conduct the voltage signal to a measuring equipment. However, this system of obtaining voltage measurement is not reliable due to the fact that the signal obtained from the bushing is very weak, so the measurement is influenced by any stray capacitance arising between the voltage presence detector and the measuring circuit. These stray capacitances are basically due to the cables joining the detection device and the measuring equipment. Given that this connection in done in the field, without any control over the type of cable used or over the layout thereof, these stray capacitances are unpredictable and usually variable over time. Therefore, the signal obtained from the indicators is not reliable for applications such as those described in this patent. Finally, this way of obtaining the voltage measurement means that the system is not in compliance with the international standards IEC 61243-5 and IEC 61958, which is a safety standard for people and property.

The preceding solution further has the risk that due to a defect in the measuring circuit a defect occurs in the voltage presence/absence indicating or detecting circuit and this provides an erroneous diagnosis of the voltage presence indication, this being a risk for operators.

For the purpose of preventing this type of errors, a second electric screen is sometimes used embedded in the bushings for voltage measurement, whereby two independent circuits are formed, one for voltage measurement and the other one for voltage detection, associating each of the circuits with its corresponding electric screen. This type of solution is the one described in patent document EP 0851442.

However, this solution involves the use of a special, complex-design bushing due to the integration of two electric screens embedded therein, which further involves an increase in the cost of said bushing. The greater technical complexity of the bushing obliges installing them only in that equipment in which voltage measuring equipment will be installed. Therefore, from the manufacturing point of view, it involves the customization of equipment, interrupting the standardization thereof, which leads to the need to manufacture and store different types of bushings and equipment, making their handling more expensive and complicated, with the added factor of being able to be out of stock due to a higher demand for equipment of a certain type than what was expected.

The use of voltage detection and/or measurement in a simple and standardized manner enables carrying out integrated control equipment with a series of features. These applications include, for example, establishing directionality of the faults, the automatic sectionalization of spans of line or carrying out advanced fault passages. All these features are necessary due to the fact that distribution lines are not defect-free (flaw in isolation) between phases, and between phase and ground, which are usually eliminated by the substation head switch. When this occurs, the fault span must be delimited as quickly as possible in order to restore service for the remaining customers. To locate and delimit the fault span, spans of the distribution grid are usually sectionalized and then the head switch is closed. This fault locating system makes defects occur up to the exact location of the damaged span, requiring a large number of operations to identify the defective area and reinstate service in the healthy spans, with the subsequent damage for customers due to the time used to reinstate service. For this reason, remote control centers and motorized equipment are used more and more such that the operations can be carried out from the control post instead of going to the centers to operate on the grid, thus reducing service restoration times. However, locating defects based on the trial and error system causes drawbacks for the customers, fleeting production of voltage which again disappears, and an accelerated aging of equipment connected to that grid. To that end, fault passage detection is occasionally used to identify a fault span. When a defect occurs between phases or between phase and ground, the substation head switch opens and eliminates the fault. Electronic devices provided with fault passage detection installed in the transformation or distribution centers through which the fault current has passed indicate the passage thereof, aiding the operator in identifying the damaged grid span.

The functionality of these electronic control/protection devices, however, is not error free in their operation, occasionally giving rise to incorrect signaling. One of the causes of this malfunction is due to the fact that occasionally they are analog equipment, and therefore they signal when they detect a high intensity peak. This intensity peak can occur in situations in which there is no fault in the grid span controlled by the electronic device. Therefore, in the event that a fault occurs in a grid span, the head switch opens the circuit and closes it again automatically, which is called resetting, in case the fault that occurred has been eliminated on its own. When the head switch closes the circuit, a transient intensity occurs in the grid with a high peak due to the connection current of the grid transformers. This intensity is not the product of a defect, rather of the usual performance of the transformer in its connection, and however the intensity produced in the grid can be detected as a fault current by analog devices. Logically, after this first resetting, all the fault passage detectors indicate the passage thereof and confuse the operator in identifying the damaged span.

For the purpose of preventing this type of errors, electronic control/protection devices occasionally incorporate means for detecting an overintensity or fault intensity in addition to the voltage presence detection. In these cases the fault passage is indicated only when the passage of a high current is detected and then is followed by a period with no voltage in the line. This solution is valid for the case in which, after the first resetting, there is not another head opening. In contrast, in the event that there is a new opening and this is definitively maintained due to the fact that the fault continues to exist, the connection current of the transformers, together with the voltage absence, make all the fault passage indicators signal the passage thereof. Fault passage detectors thus erroneously indicate faultless spans as fault spans, which does not aid the operators in restoring service.

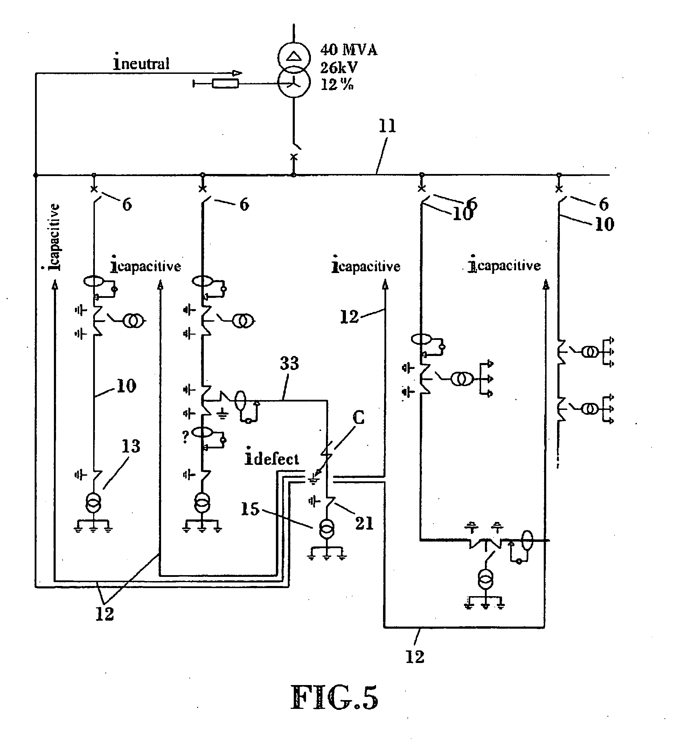

Another phenomenon which may give rise to incorrect signaling of the fault passage occurs due to the passage of capacitive currents. In any line through which a single-phase or three-phase alternating current circulates there are charging currents due to the capacitance distributed in the entire length of the line. The value of these currents depends on the voltage, on the length of the line, relative position of the conductors and on the type of cables, insulated or bare conductor cables. During normal operation, the capacitive current is small. In the power distribution grid, and especially with underground cables and a neutral isolated regimen, when a defect occurs between a phase and ground, discharge currents for the distributed capacitances of the line, referred to as return capacitive currents, occur in the parallel lines to the defective line. These return currents make the fault passage indicators signal incorrectly. Therefore, there is a grid configuration in which voltage presence detection together with an overintensity or fault intensity detection is not sufficient to correctly indicate a fault. Figure 5 illustrates the case in which a branch occurs from a line starting from the substation, i.e. the substation switch protects two lines. In this case, when the switch opens the circuit, both lines are without voltage, therefore the fault passages of both lines will indicate the existence of a fault. It will correctly indicate some fault passages and will indicate others erroneously due to the fact that the intensity that they have detected is a return capacitive intensity. In this manner, in the case of grids with high return capacitive intensities and branches coming from the same substation, fault passages combining voltage absence and high intensity passage do not always correctly indicate the existence of a fault.

Finally, to quickly restore service from a remote control post, the integrated control/protection device must be able to receive orders and in turn operate on the switch gear. However, errors may occasionally occur in the transmission of the command, or the command is not carried out due to a failure in the actuation mechanism of the switch gear to which the command is transmitted. The operator can thus interpret that the equipment in the grid are arranged in a certain manner (closed, sectionalized or grounded), and the reality is actually quite different, therefore the restoration of power service becomes complicated since the actual situation of the grid is unknown.

### DESCRIPTION OF THE INVENTION

The control/protection device object of the present invention relates to an assembly formed by voltage and intensity capture means and a three-phase numerical electronic device, integrated in the electrical equipment of power distribution installations such as transformation centers, distribution centers or substations, such that the use of racks above the equipment or of wall racks as an added element is prevented. A three-phase and numerical device is understood as a device that is able to measure and treat by means of calculation instant and discrete intensity and/or voltage values of each of the phases. This allows calculating effective voltage and intensity values, homopolar voltage and intensity values, energy, power, etc.

The control/protection device allows carrying out both locally and remotely operation applications, local control, automations, interlocks, voltage presence/absence detection, detection of anomalies, measurements of intensity, of transformer temperature, of gas pressure, of the oil level, etc., as well as implementing in coordination with the head protection curves the fault passage detection function in those grids in which the return capacitive currents may reach a magnitude that is greater than the nominal adjustment magnitude of the protection curve in the head electronic device. A single control/protection device is thus provided which performs the functions of several electronic equipments, reducing the dimensions of each of the electrical equipments in which it is integrated, obtaining electrical installations that are more compact, simpler and more reliable to put into operation.

The control/protection device object of the invention is based on the use of a new voltage measuring circuit, which uses a capacitive voltage signal provided by a single screen inserted in the bushings and which is normally used for voltage presence/absence indication or detection.

The voltage measuring circuit is arranged in series with the voltage presence/absence indicating or detecting circuit. The voltage measuring circuit is arranged between the capacitive voltage connection provided by the screen of the bushing and the voltage presence/absence indicating or detecting circuit or after the voltage presence/absence indicating or detecting circuit and comprises elements which do not affect or interrupt the voltage presence indicating/detecting circuit, such as for example a low voltage transformer, which a possible failure in the measuring circuit would allow maintaining the voltage presence detecting circuit, which circuit constitutes a safety element for operators. It is thus possible to prevent the use of two different voltage signals for both applications, which involves preventing the two screens mentioned in the bushings of patent EP 0851442. Therefore, standard bushings are used for this application, facilitating its engineering, allowing the customization of the boxes in the final manufacturing step, simplifying and favoring a planned and regular manufacture of equipment. Furthermore, due to the particularity that the voltage signal is obtained directly from the signal provided by the screen of the bushing, the precision of the obtained voltage values is greatly increased. In turn, due to the fact that the control/protection device and the bushings are installed in the factory and are fixed and unchanging overtime, they can be calibrated and adjusted to obtain very precise voltage measurements.

Additionally, since it is an electronic device integrated in the electrical equipment of the installation and calibrated in the factory, on site wiring between the control/protection device and the elements associated thereto, such as the wiring between the control/protection device and the voltage presence/absence indicating or detecting circuit, through which the capacitive voltage signal is obtained, is prevented, preventing uncontrolled stray capacitances which distort the precision of the measurement.

As stated, the control/protection device object of the invention incorporates an intensity measurement based on intensity sensing devices integrated in the electrical equipment, which are installed, adjusted and checked in the factory, such that on site assembly and connecting tasks are eliminated, eliminating installation errors of the sensing devices and reducing the manual labor time and cost in the installation. In this way, once the cables of the distribution grid are connected, the integrated control system is operative. This way of installing the intensity sensing devices is described in patent ES2174754.

The control/protection device object of the invention allows identifying the fault span of a line by means of a fault passage detection function, with the feature that said fault passage detection function identifies the permanent defects combining the overintensity or fault intensity functions together with a three-phase voltage detecting logic. The defective area is thus identified immediately in order to restore service in the healthy spans, the number of operations on the elements of the grid, and accordingly the number of demands therein, is reduced, prolonging the useful life of the equipment.

Intensity detection is done by calculating the effective values thereof, therefore the circulation of connection intensities of transformers, containing a continuous intensity transient, making them not be perceived as fault intensities, preventing incorrect detections. In turn, due to the fact that the fault passage function is implemented by using voltage detection in case of fault and if a prolonged voltage absence occurs, the fault passage is indicated.

To prevent the problems of fault passage indication in the case of two lines sharing the same automatic switch in the substation, the control/protection device has been provided with the possibility of coordinating its operation with other devices by means of what are referred to as trip curves. So to cause the fault indication, the intensity must circulate for a time which is a function of the value of said intensity. Therefore, for very high intensities, the time necessary for indicating the fault passage is reduced, since if the intensity has a high value it is because there actually is a fault in that grid span. However, since the substation switch has already opened the circuit, the fault passage indicator through which the return capacitive intensity circulates has not had time to signal the fault, whereby only the indicators through which the fault has actually passed signal correctly.

The previous system can be applied to several neutral isolated systems, however when the neutral regimen is compensated, the intensity in the line in which the fault occurs may be less than that of the adjacent lines. In this case, the directionality of the intensities must be established for the fault passage detection, i.e. it is necessary to determine if the circulation of a high intensity is due to the presence of a fault in the line (circulation of the intensity towards the power consumption points) or if it is a return capacitive intensity (circulation of the intensity towards the power supply point). Incorrect fault detection due to the return capacitive currents in the parallel lines to the defective line is thus prevented. This discrimination is done by using not the voltage presence or absence, but rather the voltage measurement provided by the new voltage measuring/presence detecting circuit together with the intensity detection. The measurement of the three phase voltages of the grid allows determining the socalled polarization voltage, which allows determining the direction of the intensity.

Another application of this device is the automatic sectionalization of spans of defective line using sectionalizing switches instead of automatic switches (much more expensive than the former). To that end, the control/protection device is associated to a sectionalizing switch which disconnects the defective span of a line after a programmable number of connection-disconnection sequences of the head switch. By using the periods in which the head switch is open due to a fault detection, and therefore there is no voltage in the circuit, the control/protection device orders the sectionalizing switch to open, such that the line open by the sectionalizing switch has been eliminated therefrom the next time that the head switch closes the circuit. If the defect was in the sectionalized line, service is permanently reinstated in the rest of the circuit without needing the intervention of operators.

Finally, in order for the grid supervisor to know at all times the situation of the switches, sectionalizing switches and ground sectionalizing switches of the grid, the integrated control/protection device is able to provide the state of these equipment as a result of a series of registers in which it stores data and historic calculations of events and magnitudes, as well as of digital inputs reporting the situation of said equipment. To be able to report the equipment has a communications port allowing it to receive commands and transmit information on equipment, electric magnitudes, temperatures, etc.

### DESCRIPTION OF THE DRAWINGS

To complement the description being made and for the purpose of aiding to better understand the features of the invention according to a preferred practical embodiment thereof, a set of drawings is attached as an integral part of said description in which, with an illustrative and non-limiting character, the following has been depicted:
Figure 1 is a basic representation of the one-line diagram according to the state of the art relating to the measuring circuit (B) and the voltage presence/absence indicating or detecting circuit (A), in which the voltage presence indicating and/or detecting circuit (A) is connected in parallel with the voltage measuring circuit (B). A capacitor (2) with capacitance value C1 is connected between the measuring circuit (B) and the main line (1).
Figure 2 a and 2 b represent the one-line diagram relating to the measuring and voltage presence detection circuit according to the preferred embodiment of the invention, in which the voltage measuring circuit (B) obtains the voltage signal of the sensing devices/screens (2') through a low voltage transformer, toroidal or not, connected in series with the voltage presence indicating circuit (A), without interrupting it.
Figure 3 represents the voltage sensing device (2'), electric field unifying screen, integrated in the bushing (3) and the intensity sensing device (5).
Figure 4 represents a way of installing the ultrasensitive intensity sensing devices for ground faults (22) on the bushings (3) to which the cables of the distribution grid are connected.
Figure 5 represents the one-line diagram of a typically underground power distribution grid showing a main line (11) and the branches (10, 33) coming from it. Each branch is provided with a head switch (6). In turn, the transformation centers are located in said branches (13, 15).
Figure 6 represents the one-line diagram of an aerial power distribution grid showing one of the main power lines (8) provided with a head switch (6) and the branches (9, 11) coming from it, provided with a sectionalizing switch (7) and the control/protection device.
Figure 7 represents the scheme of an installation of a transformation/distribution center in which the equipment according to the preferred embodiment of the invention is installed.
Figures 8-11 represent the definite time, normally inverse, very inverse and extremely inverse curves, implemented for the overintensity or fault intensity function between phases and phase and ground.
Figure 12 represents the one-line diagram corresponding to a power distribution grid in which the transformation center or distribution center (27) has two input lines (23, 26).
Figure 13 represents the head protection curve (28), the ground fault instantaneous curve (29), the return capacitive current curve (31) and the protection curve (30) which can be implemented in the control/protection device (14).
Figure 14 represents a high/medium voltage line in which there is an open phase.
Figure 15 represents the circuit diagram in a transformer fed by a line such as the one represented in Figure 14.

### PREFERRED EMBODIMENT OF THE INVENTION

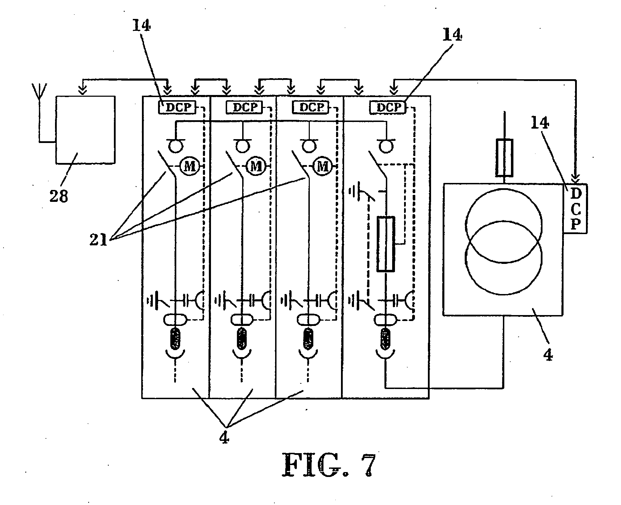

The invention relates to a control/protection device which is installed in the electrical equipment comprised in a power distribution installation, such as for example, a transformation center or a power distribution center or substation. As shown in Figure 7, the control/protection device (14) is integrated in the electrical equipment (4), such that the use of independent racks above the electrical equipment (4) or wall racks as an added element is prevented. The control/protection device (14) is a three-phase numerical electronic device that can measure instantaneous intensity and voltage values of each of the phases and determine and measure homopolar voltages and intensities, energy, power, etc., as well as perform applications such as automatic sectionalization of fault lines, local control, remote control operations, automations, interlocks, etc., related to the current and future automation needs of transformation centers, distribution centers and substations. A single control/protection device (14) is thus provided which performs the functions of several electronic equipments, reducing the global dimensions of the installation.

Each electrical equipment (4) is provided with a control/protection device (14) that is able to treat voltage and intensity measurement signals, without needing auxiliary converters.

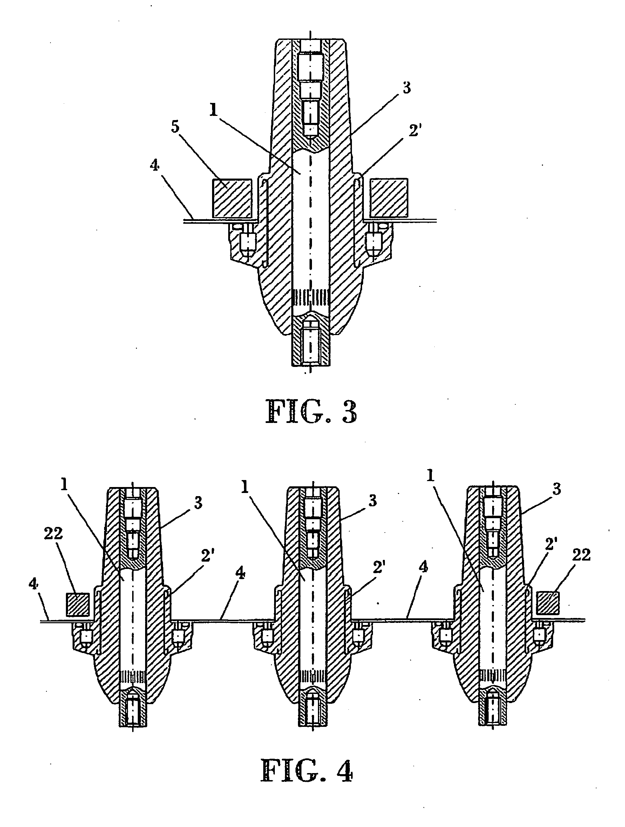

Voltage measurement is preferably carried out by means of the circuit of the Figures 2a-2b through a capacitive voltage connection (2) of the bushings (3) of the electrical equipment (4), as is shown in Figure 3, using the electric screen (2') for controlling the electric field of the bushings (3) as a capacitive coupling for extracting the voltage signal, preventing the need to use conventional voltage transformer systems.

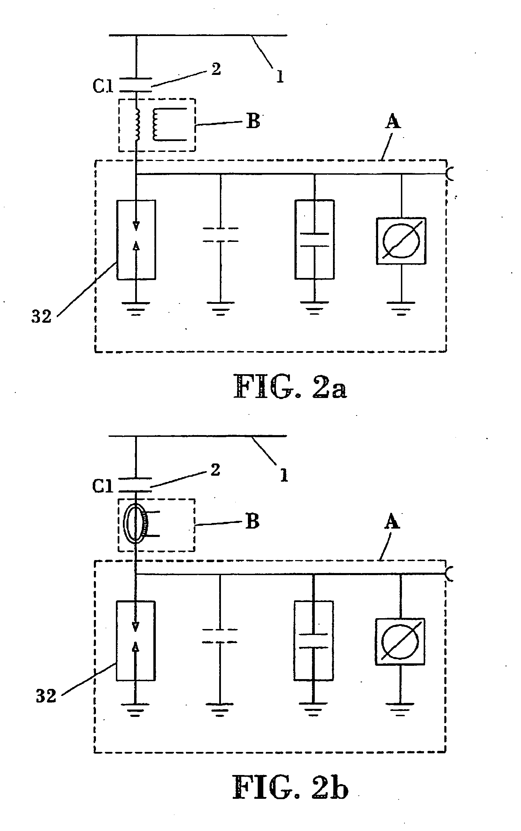

For the function corresponding to the voltage presence/absence indication or detection and measurement, as shown in Figures 2a-2b, the control/protection device (14) implements a circuit comprising a capacitive voltage connection (2), a voltage limiting device (32), a voltage measuring circuit (B) and a voltage presence/absence detecting circuit (A) respectively connected in series.

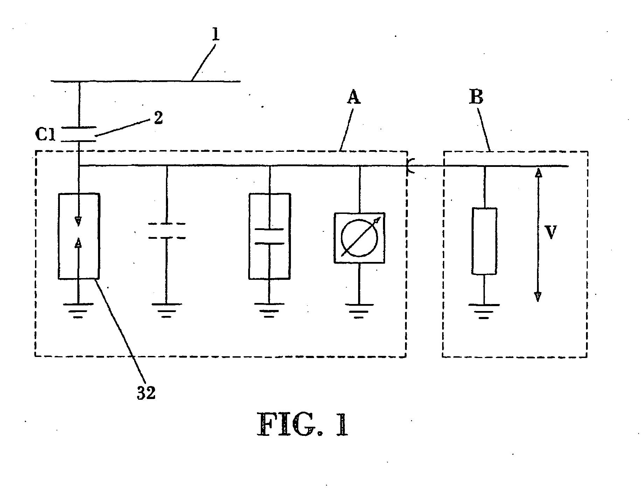

The voltage measurement is characterized in that the circuit obtains the voltage signal directly from the electric screen (2'), i.e. directly from the line. Due to the direct voltage signal measurement from the electric screen (2'), the obtained voltage values are more precise than if they were obtained from the circuit of Figure 1.

The voltage capture for the measurement could be carried out by placing an impedance in series with the voltage presence detecting circuit, however, this involves interrupting the circuit between the capacitive voltage connection (2) and the voltage presence detection (A) by introducing an element that could be damaged. On the other hand, and for the purpose of obtaining galvanic isolation between the voltage measuring circuit (B) and the capacitive voltage connection (2), the voltage measurement has been carried out by means of inserting a low voltage transformer arranged in series with the voltage presence/absence indicating or detecting circuit (A). In this way, a failure in the measuring circuit (located in the secondary circuit of the transformer) does not affect the primary circuit, in which the voltage presence indicating/detecting circuit (A) is located. The transformer further allows conditioning the voltage provided by the electric screen (2') to a value suitable for measurement. It must be indicated that the transformer used in the circuit (B) is not a high voltage transformer, rather a low voltage transformer, so it is very small in size. The implementation of the transformer may vary, being able to be a voltage transformer or a toroidal transformer/sensing device, which involves not interrupting the voltage presence/absence indicating/detecting circuit (A). The continuity in the circuit occurs since the only thing separating the capacitive voltage connection (2) from the circuit (A) is a conducting element, there are no passive elements such as resistances or capacitors in the intermediate area, or any active element such as transistors, amplifiers, etc. This circuit configuration prevents the need to integrate a second voltage sensing device in the bushings, such that standard bushings are obtained which facilitate their engineering, simplifying and favoring a planned and relatively regular manufacture of equipment.

The voltage presence/absence detection and measurement function is implemented for each and every one of the phases comprised in the installation, such that both the voltage presence/absence indication and the instantaneous measurement thereof in each of the phases at all times is obtained. The system can obviously be implemented only in one of the phases, since both the sensing and the electronic devices can be carried out in a modular manner.

The intensity measurement is carried out by means of toroidal intensity sensing devices (5), as shown in Figure 3, which are installed outside the bushings (3) and at the base thereof, such that said toroidal intensity sensing devices (5) are integrated in the electrical equipment (4), installed and checked in the factory, thus eliminating installation errors of the sensing devices and detecting ground faults or faults between phases in the connection of the box.

For the detection of ground faults having very small values a toroidal transformer (22) can be used, installed as indicated in Figure 4, with the previously explained advantages or in the medium voltage cables in the case of not having enough space.

The control/protection device (14) comprises a fault passage detection function which allows identifying the span of the defective line due to a fault between phases or between phase and ground in all the circumstances described above. This function allows identifying the fault span in a quick and reliable manner in order to restore service to the remaining customers. To that effect, as shown in Figure 5, when a defect occurs at a point (C) of a line (33), the head switch (6) opens the defective line. At the same time, the control/protection device (14) installed in the transformation center (15) depending on the defective line (33) indicates the fault passage. The fault passage indications in automated transformation or distribution centers can be observed from the control center and the operation command of the corresponding switch gear (21) can be emitted from said center.

To ensure correct fault passage indication in all the circumstances, as shown in Figure 5, the fault passage function implementing the control/protection device (14) does so by means of the combination of the overintensity or fault intensity functions together with a voltage detecting/measuring logic. It thus allows differentiating the defective spans of line (33) from the lines (10) which are not defective, but through which a return capacitive current (12) circulates. This correct operation is achieved by making the control/protection device (14) operate by combining intensity passage together with the presence/voltage absence, or by means of coordinating the trip curves or determining the directionality of the fault based on the voltage measurement, according to the complexity of the grid in which the device (14) is going to be installed.

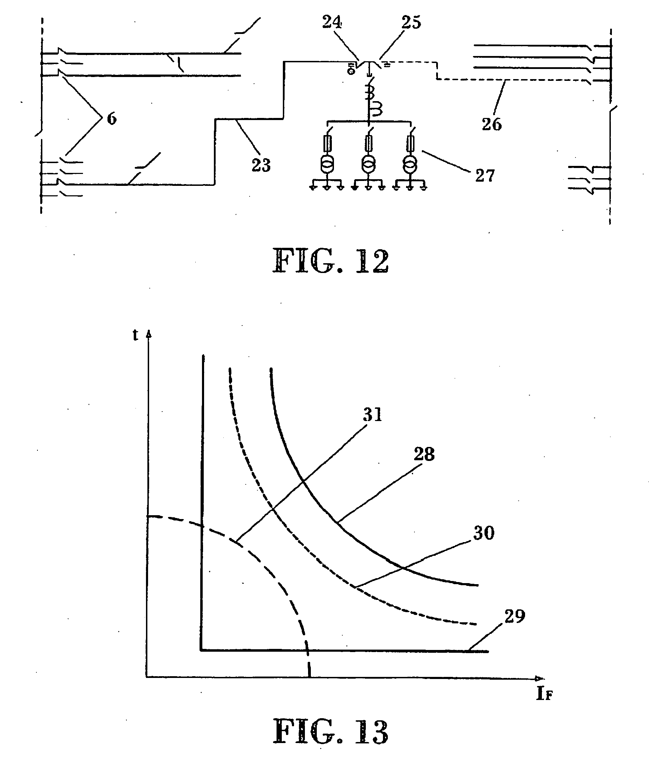

The control/protection devices (14) of the parallel lines (10) through which a return capacitive current (12) circulates detect said current as a fault current but they do not act due to the fact that a voltage absence does not occur in the lines (10) they depend on. For high return capacitive currents and branches coming from the same substation line, as shown in Figure 13, the device (14) implements an operation curve (30) in coordination with the head protection curve (28), such that when a defect occurs in a branch and the head opens, the remaining branches through which a high return capacitive current has passed do not indicate the fault passage even though they are left without voltage. In turn, given that the device (14) is numerical, it carries out the calculation of the effective currents, distinguishing the connection currents of the transformer (made up of the fundamental component and its harmonics) from the fault currents, preventing erroneous indications of the connection currents as fault passages.

Finally, another way of discriminating if the overintensity or fault intensity which is detected is due to a fault in the line or to a return capacitive intensity is to use a function determining the direction of the detected fault currents, carrying out the calculations between the intensity and the polarization magnitude. Either voltage sensing devices or preferably the circuit indicated in Figures 2a-2b are used to determine the polarization magnitude. For example, for its application in ground faults, the combination between the homopolar voltage, used as polarization magnitude, and the detected intensity l₀ allows discriminating if it is a fault current with a downstream direction or if it is a return capacitive current with an upstream direction, as shown in Figure 5.

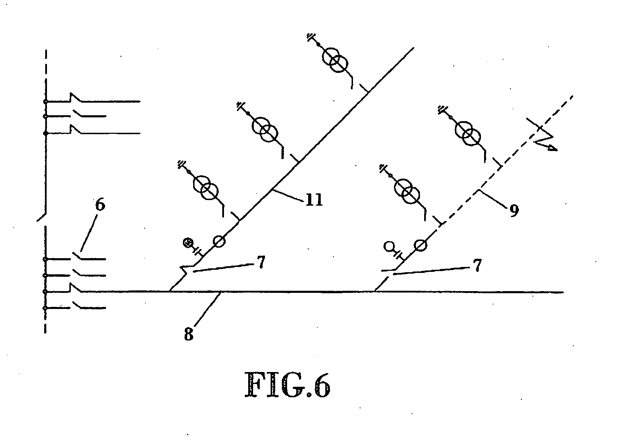

As shown in Figure 6, a particularly relevant application for distribution grids is that the control/protection device (14) allows disconnecting the defective span of a line (9) through an automatic sectionalizing switch (7). Its operation is similar to that of the fault passage detection function, complementing with the automatic opening of the sectionalizing switch (7) once the automatic head switch (6) has eliminated the fault. This opening is carried out in the periods in which there is no voltage in the line due to any of the resettings that the head switch (6) may carry out. So for example, a defect in the line (9) involves the trip of the switch (6) of the substation or distribution center, followed by a resetting. If this is unsuccessful, another trip of the head switch (6) occurs. The sectionalizing switch (7) which has detected the overintensity or fault intensity passage checks that there is no voltage, and then opens the line (9) in the span in which it is installed. The second resetting of the switch (6) achieves feeding the line (8) again without the span in which the defect is located. This same operation can be programmed so that it is carried out after the second or successive resettings.

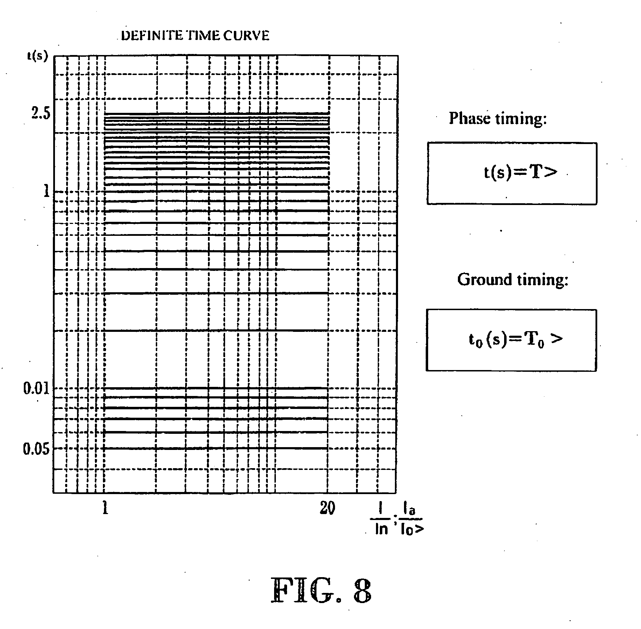

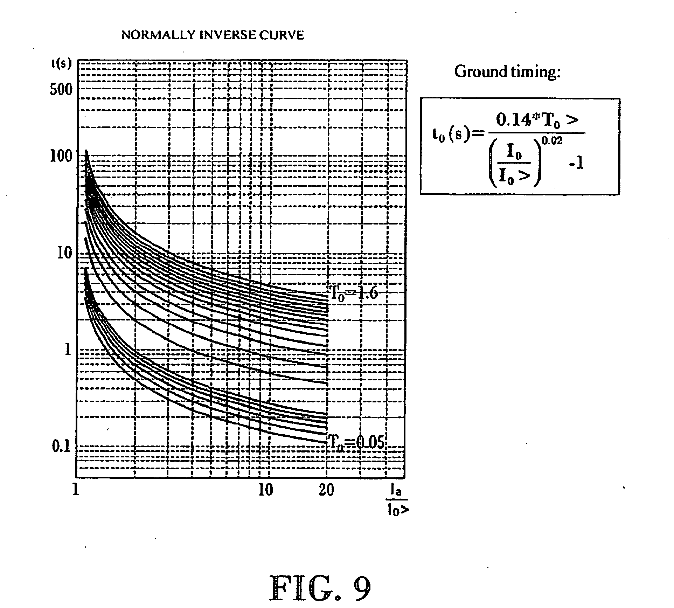

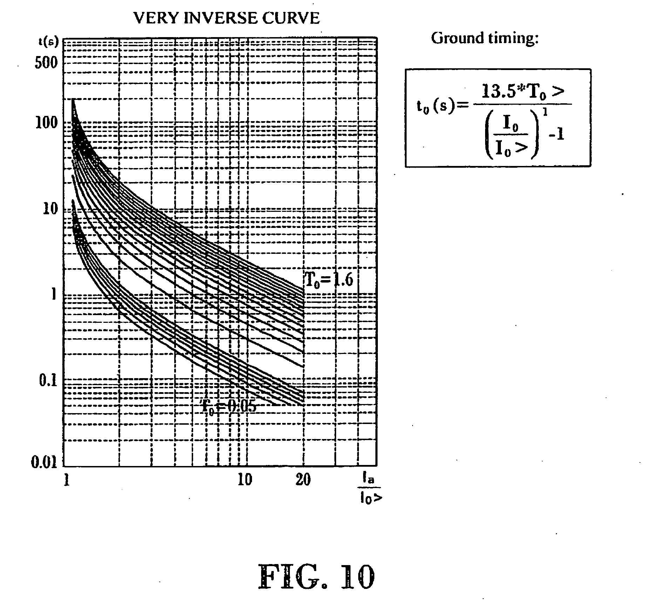

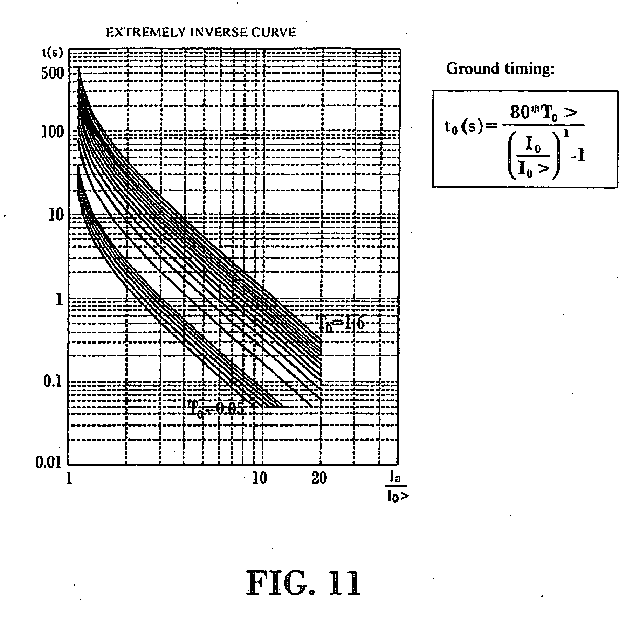

The overintensity or fault intensity function included in the control/protection device (14) is implemented for each of the phases and for ground, carrying out the fault detection between phases and the fault detection between phase and ground. To that end, the overintensity or fault intensity function is associated to definite time detection curves (see Figure 8) for fault detection between phases and to definite time, normally inverse, very inverse and extremely inverse curves (see Figures 8, 9, 10 and 11 respectively) for fault detection between phase and ground. The control/protection device (14) can also implement an ultrasensitive fault detection functionality between phase and ground, using to that end a toroidal transformer (22) encompassing all the phases, as shown in Figure 4, such that it is independent of the intensity of the phases preventing errors of the toroidal phase intensity sensing devices (5) and current detection between phase and ground having a very small value, as may occur in grids with neutral isolated, neutral compensated or very resistive terrains, is ensured. As a general rule, the phase-ground defective current detection of less than 10% of the nominal phase intensity is ensured.

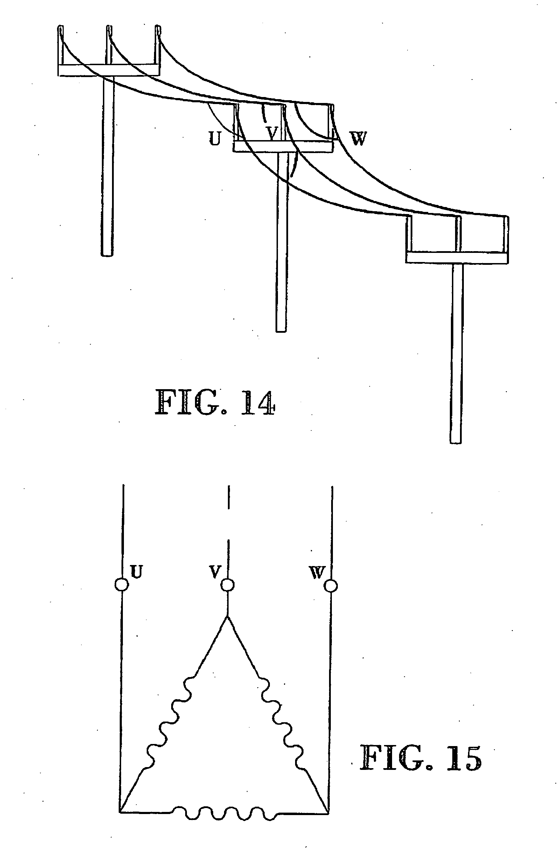

Another application of the control/protection device (14) is open phase detection in power lines, Figure 14. In this case, a voltage presence indicator/detector installed in a transformation center would observe that there is voltage in the open phase (V), since the transformer of the transformation center, with the primary circuit connected in delta, Figure 15, would have in phase V a voltage comprised between phase U and W. Given that this voltage is greater than the voltage indication threshold, voltage presence would be detected/indicated, which is correct, but an alarm that the line has an open phase (V) would not occur. A real measurement of the voltage in the phase would occur with the voltage measuring system used in the control/protection device (14), and therefore the problem is detected since it is less than the nominal voltage of the two other phases.

The control/protection device (14) integrates a control function which, by means of the digital inputs and outputs, allows receiving control and measurement signals relating to temperature, pressure, fluid level, etc., receiving and/or transmitting a command to operate the switch, sectionalizing switch or ground sectionalizing switch of the equipment (4) in which it is installed. It can further carry out supervision functions, since it can receive the state of the switch, sectionalizing switch or ground sectionalizing switch. The integrated control device controls that the operation of the switch, sectionalizing switch or ground sectionalizing switch is carried out within the time allowed by the motorization of the electrical equipment (4). In the event that the command is not carried out in the pre-established time, the feed of the actuation motorization is cut off. Given that the integrated control device has information on the state of the electrical equipment (4), it is possible to prevent erroneous operations, such as for example, grounding a line with voltage. So when voltage presence is detected in a line, and due to a ground command therefor, which would cause a short-circuit, the integrated control device can block said action, preventing the accident.

On the other hand, the control/protection device (14) has an event register in which the latest defects detected by the same are stored. It further stores the total number total of detected faults, as well as the different configuration parameters. The integrated control device can report all available data to the operating office by means of the communications port and allows carrying out remote control applications for transformation and distribution centers, implementing the control and the supervision of each electrical equipment (4). As shown in Figure 7, the use of the integrated control devices (14) and a data concentrator and equipment controller (28), allows viewing and operating each position of the switch gear integrated in the electrical equipment (4) locally or remotely.

## Claims

1. A control/protection device for power distribution grids based on the capture/measuring of signals coming from the power grid and/or from the electrical equipments of power distribution installations, the control/protection device being incorporated, in all or part of the mentioned electrical equipment and comprising an electrical circuit comprising a capacitive voltage connection (2) of the mentioned electrical equipment (4), a voltage limiting device (32), a voltage measuring circuit (B) and a voltage presence/absence indicating or detecting circuit (A), **characterized in that** the voltage measuring circuit (B) is connected in series with the capacitive voltage connection (2) and the voltage presence/absence indicating or detecting circuit (A).

2. A control/protection device for power distribution grids according to claim 1, **characterized in that** the capacitive voltage connection (2) is obtained from electric field standardizing screens (2') integrated in connection bushings (3) of the power supply cables to the electrical equipment (4).

3. A control/protection device for power distribution grids according to claim 1, **characterized in that** the voltage measuring circuit (B) is arranged between the voltage presence/absence indicating or detecting circuit (A) and the capacitive voltage connection (2).

4. A control/protection device for power distribution grids according to claim 2, **characterized in that** the voltage measuring circuit (B) comprises a low voltage transformer for voltage measurement.

5. A control/protection device for power distribution grids according to claim 4, **characterized in that** the voltage measuring circuit (B) is galvanically isolated from the capacitive voltage connection (2).

6. A control/protection device for power distribution grids according to claim 5, **characterized in that** it comprises an independent voltage measuring circuit (B) for each of the phases of the electrical equipment (4).

7. A control/protection device for power distribution grids according to claim 1, **characterized in that** it additionally comprises intensity measuring means of the electrical equipment (4).

8. A control/protection device for power distribution grids according to claim 7, **characterized in that** the intensity measuring means comprise at least one toroidal transformer or sensing device (5) installed on the outside at the base of a connection bushing (3) of the power supply cables of the electrical equipment (4).

9. A control/protection device for power distribution grids according to claim 7, **characterized in that** the intensity measuring means comprise at least one toroidal transformer or sensing device (5) arranged inside a connection bushing (3) of the power supply cables of the electrical equipment (4).

10. A control/protection device for power distribution grids according to claim 9, **characterized in that** it additionally comprises protection curves which are of the same type as the head protection curves of the distribution grid for fault passage detection.

11. A control/protection device for power distribution grids according to claim 7, **characterized in that** the intensity measurement, together with the measurements obtained from the voltage measuring circuit (B) and from the voltage presence/absence indicating or detecting circuit (A), allows determining the fault passage.

12. A control/protection device for power distribution grids according to claim 7, **characterized in that** the intensity measurement, together with the measurement obtained from the voltage measuring circuit (B), allows determining the directionality of the fault passage.

13. A control/protection device for power distribution grids according to claim 10, **characterized in that** the fault passage detection allows the automatic sectionalization of lines.

14. A control/protection device for power distribution grids according to claim 1, **characterized in that** it additionally comprises means for detecting the position of the switch, sectionalizing switch or ground sectionalizing switch of the electrical equipment (4) in which it is installed.

15. A control/protection device for power distribution grids according to claim 1, **characterized in that** it additionally comprises means for receiving and/or transmitting an operation command of the switch, sectionalizing switch, ground sectionalizing switch.

16. A control/protection device for power distribution grids according to claim 1, **characterized in that** it additionally comprises means for the receiving control and measurement signals relating to temperature, pressure, fluid level, etc.

17. A control/protection device for power distribution grids according to claim 1, **characterized in that** it additionally comprises recording means for storing the detected defects, as well as the different configuration parameters.

18. A control/protection device for power distribution grids according to claim 7, **characterized in that** the voltage presence/absence indicating or detecting circuit (A) allows carrying out a ground prevention interlock preventing the ground of the switch (21) of the electrical equipment (4) when voltage is detected in the line.

19. A control/protection device for power distribution grids according to claim 7, **characterized in that** the device (14) allows ground fault detection for each of the phases.

20. A control/protection device for power distribution grids according to claim 1, **characterized in that** it additionally comprises a toroidal transformer (22) encompassing all the phases for ground fault detection.

21. A control/protection device for power distribution grids according to claim 19, **characterized in that** ground fault detection allows detecting defective currents of less than 10% of the nominal phase intensity.

22. A control/protection device for power distribution grids according to claim 1, **characterized in that** it comprises means for measuring the instantaneous voltage and intensity values and means for calculating the effective intensity and voltage values of each phase and means for determining the homopolar voltages and intensities, energy, power, etc.

23. A control/protection device for power distribution grids according to claim 1, **characterized in that** it additionally comprises a series of digital inputs and outputs allowing to carry out remote control applications of the transformation and distribution centers, implementing the control and supervision of each electrical equipment (4).

24. A control/protection device for power distribution grids according to claim 6, **characterized in that** the individualized voltage measurement in each of the phases allows detecting an open phase at any point of the line.

25. A control/protection device for power distribution grids according to any of the previous claims, **characterized in that** the control/protection device is a three-phase device.

26. A control/protection device for power distribution grids according to any of the previous claims, **characterized in that** the control/protection device is integrated in the electrical equipment (4).

## Patentansprüche

1. Steuer-/Schutzvorrichtung für Stromverteilernetze, basierend auf der Erfassung/Messung von Signalen, welche von dem Stromnetz und/oder den elektrischen Geräten von Stromverteileranlagen kommen, wobei die Steuer-/Schutzvorrichtung in allen oder in Teilen der genannten elektrischen Geräte vorgesehen ist und eine elektrische Schaltung aufweist, welche einen kapazitiven Spannungsanschluss (2) des genannten elektrischen Geräts (4), eine Spannungsbegrenzungsvorrichtung (32), eine Spannungsmessschaltung (B) und eine das Vorhandensein/Nichtvorhandensein von Spannung anzeigende oder erkennende Schaltung (A) umfasst, **dadurch gekennzeichnet, dass** die Spannungsmessschaltung (B) in Reihe mit dem kapazitiven Spannungsanschluss (2) und der das Vorhandensein/Nichtvorhandensein von Spannung anzeigenden oder erkennenden Schaltung (A) verbunden ist.

2. Steuer-/Schutzvorrichtung für Stromverteilernetze nach Anspruch 1, **dadurch gekennzeichnet, dass** der kapazitive Spannungsanschluss (2) durch die Verwendung von elektrische Felder standardisierenden Abschirmungen (2') gebildet ist, welche in Anschlussbuchsen (3) der zu den elektrischen Geräten (4) führenden Stromversorgungskabel integriert sind.

3. Steuer-/Schutzvorrichtung für Stromverteilernetze nach Anspruch 1, **dadurch gekennzeichnet, dass** die Spannungsmessschaltung (B) zwischen der das Vorhandensein/Nichtvorhandensein von Spannung anzeigenden oder erkennenden Schaltung (A) und dem kapazitiven Spannungsanschluss (2) angeordnet ist.

4. Steuer-/Schutzvorrichtung für Stromverteilernetze nach Anspruch 2, **dadurch gekennzeichnet, dass** die Spannungsmessschaltung (B) für die Spannungsmessung einen Niederspannungstransformator aufweist.

5. Steuer-/Schutzvorrichtung für Stromverteilernetze nach Anspruch 4, **dadurch gekennzeichnet, dass** die Spannungsmessschaltung (B) gegenüber dem kapazitiven Spannungsanschluss (2) galvanisch isoliert ist.

6. Steuer-/Schutzvorrichtung für Stromverteilernetze nach Anspruch 5, **dadurch gekennzeichnet, dass** sie eine unabhängige Spannungsmessschaltung (B) für jede der Phasen der elektrischen Geräte (4) aufweist.

7. Steuer-/Schutzvorrichtung für Stromverteilernetze nach Anspruch 1, **dadurch gekennzeichnet, dass** sie zusätzlich Intensitätsmesseinrichtungen des elektrischen Geräts (4) umfasst.

8. Steuer-/Schutzvorrichtung für Stromverteilernetze nach Anspruch 7, **dadurch gekennzeichnet, dass** die Intensitätsmesseinrichtung mindestens einen Ringtransformator oder eine Erfassungsvorrichtung (5) aufweist, die außen an der Basis einer Anschlussbuchse (3) der Stromversorgungskabel der elektrischen Geräte (4) angebracht ist.

9. Steuer-/Schutzvorrichtung für Stromverteilernetze nach Anspruch 7, **dadurch gekennzeichnet, dass** die Intensitätsmesseinrichtung mindestens einen Ringtransformator oder eine Erfassungsvorrichtung (5) aufweist, die in einer Anschlussbuchse (3) der Stromversorgungskabel der elektrischen Geräte (4) angeordnet ist.

10. Steuer-/Schutzvorrichtung für Stromverteilernetze nach Anspruch 9, **dadurch gekennzeichnet, dass** sie zusätzlich Schutzkurven aufweist, welche von dem selben Typ sind, wie die Hauptschutzkurven des Verteilernetzes zur Fehlerdurchgangserkennung.

11. Steuer-/Schutzvorrichtung für Stromverteilernetze nach Anspruch 7, **dadurch gekennzeichnet, dass** die Intensitätsmessung, zusammen mit den von der Spannungsmessschaltung (B) und der das Vorhandensein/Nichtvorhandensein von Spannung anzeigenden oder erkennenden Schaltung (A) erhaltenen Messungen, die Bestimmung des Fehlerdurchgangs ermöglicht.

12. Steuer-/Schutzvorrichtung für Stromverteilernetze nach Anspruch 7, **dadurch gekennzeichnet, dass** die Intensitätsmessung, zusammen mit der von der Spannungsmessschaltung (B) erhaltenen Messung, die Bestimmung der Richtung des Fehlerdurchgangs ermöglicht.

13. Steuer-/Schutzvorrichtung für Stromverteilernetze nach Anspruch 10, **dadurch gekennzeichnet, dass** die Fehlerdurchgangserkennung die automatische Sektionalisierung von Leitungen ermöglicht.

14. Steuer-/Schutzvorrichtung für Stromverteilernetze nach Anspruch 1, **dadurch gekennzeichnet, dass** sie zusätzlich eine Einrichtung zum Erkennen der Stellung des Schalters, des Sektionalisierungsschalters oder des Masse-Sektionalisierungsschalters des elektrischen Geräts (4), in dem sie eingebaut ist, aufweist.

15. Steuer-/Schutzvorrichtung für Stromverteilernetze nach Anspruch 1, **dadurch gekennzeichnet, dass** sie zusätzlich eine Einrichtung zum Empfangen und/oder Senden eines Operationsbefehls des Schalters, des Sektionalisierungsschalters oder des Masse-Sektionalisierungsschalters aufweist.

16. Steuer-/Schutzvorrichtung für Stromverteilernetze nach Anspruch 1, **dadurch gekennzeichnet, dass** sie zusätzlich eine Einrichtung zum Empfangen von Steuer- und Messsignalen bezüglich der Temperatur, des Drucks, des Fluidpegels etc. aufweist.

17. Steuer-/Schutzvorrichtung für Stromverteilernetze nach Anspruch 1, **dadurch gekennzeichnet, dass** sie zusätzlich Aufzeichnungseinrichtungen zum Speichern der erkannten Defekte sowie der verschiedenen Konfigurationsparameter aufweist.

18. Steuer-/Schutzvorrichtung für Stromverteilernetze nach Anspruch 7, **dadurch gekennzeichnet, dass** die das Vorhandensein/Nichtvorhandensein von Spannung anzeigende oder erkennende Schaltung (A) das Durchführen einer Masseschluss-Verhinderungssperre zum Verhindern des Masseschlusses des Schalters (21) des elektrischen Geräts (4) ermöglicht, wenn Spannung in der Leitung erkannt wird.

19. Steuer-/Schutzvorrichtung für Stromverteilernetze nach Anspruch 7, **dadurch gekennzeichnet, dass** die Vorrichtung (14) eine Massefehlererkennung für jede der Phasen ermöglicht.

20. Steuer-/Schutzvorrichtung für Stromverteilernetze nach Anspruch 1, **dadurch gekennzeichnet, dass** sie zusätzlich einen Ringtransformator (22) umfasst, der sämtliche Phasen für die Massefehlererkennung umfasst.

21. Steuer-/Schutzvorrichtung für Stromverteilernetze nach Anspruch 19, **dadurch gekennzeichnet, dass** die Massefehlererkennung die Erkennung von Fehlerströmen von weniger als 10% der nominellen Phasenintensität ermöglicht.

22. Steuer-/Schutzvorrichtung für Stromverteilernetze nach Anspruch 1, **dadurch gekennzeichnet, dass** sie eine Einrichtung zum Messen der momentanen Spannungs- und Intensitätswerte und eine Einrichtung zum Berechnen der effektiven Intensitäts- und Spannungswerte jeder Phase und eine Einrichtung zum Bestimmen der gleichpoligen Spannungen und Intensitäten, der Energie, des Stroms, etc. aufweist.

23. Steuer-/Schutzvorrichtung für Stromverteilernetze nach Anspruch 1, **dadurch gekennzeichnet, dass** sie zusätzlich eine Reihe von digitalen Eingängen und Ausgängen aufweist, die das Durchführen von Fernsteuerungsanwendungen seitens der Transformations- und Verteilungszentren ermöglichen, wodurch die Steuerung und Überwachung jedes einzelnen elektrischen Geräts (4) implementiert wird.

24. Steuer-/Schutzvorrichtung für Stromverteilernetze nach Anspruch 16 **dadurch gekennzeichnet, dass** die individualisierte Spannungsmessung in jeder der Phasen die Erkennung einer offenen Phase an jeder Stelle der Leitung ermöglicht.

25. Steuer-/Schutzvorrichtung für Stromverteilernetze nach einem der vorhergehenden Ansprüche, **dadurch gekennzeichnet, dass** die Steuer-/Schutzvorrichtung eine dreiphasige Vorrichtung ist.

26. Steuer-/Schutzvorrichtung für Stromverteilernetze nach einem der vorhergehenden Ansprüche, **dadurch gekennzeichnet, dass** die Steuer-/Schutzvorrichtung in dem elektrischen Gerät (4) integriert ist.

## Revendications

1. Dispositif de commande/protection pour des réseaux de distribution d'énergie électrique basé sur la capture/mesure de signaux provenant du réseau d'énergie électrique et/ou de l'équipement électrique d'installations de distribution d'énergie électrique, le dispositif de commande/protection étant incorporé dans la totalité ou dans une partie de l'équipement électrique mentionné et comprenant un circuit électrique comprenant une connexion de tension capacitive (2) de l'équipement électrique (4) mentionné, un dispositif de limitation de tension (32), un circuit de mesure de tension (B) et un circuit d'indication ou de détection de présence/absence de tension (A),
**caractérisé en ce que** le circuit de mesure de tension (B) est connecté en série avec la connexion de tension capacitive (2) et le circuit d'indication ou de détection de présence/absence de tension (A).

2. Dispositif de commande/protection pour des réseaux de distribution d'énergie électrique selon la revendication 1, **caractérisé en ce que** la connexion de tension capacitive (2) est obtenue à partir de blindages de normalisation de champ électrique (2') intégrés dans les douilles de connexion (3) des câbles d'alimentation pour l'équipement électrique (4).

3. Dispositif de commande/protection pour des réseaux de distribution d'énergie électrique selon la revendication 1, **caractérisé en ce que** le circuit de mesure de tension (B) est agencé entre le circuit d'indication ou de détection de présence/absence de tension (A) et la connexion de tension capacitive (2).

4. Dispositif de commande/protection pour des réseaux de distribution d'énergie électrique selon la revendication 2, **caractérisé en ce que** le circuit de mesure de tension (B) comprend un transformateur basse tension pour la mesure de tension.

5. Dispositif de commande/protection pour des réseaux de distribution d'énergie électrique selon la revendication 4, **caractérisé en ce que** le circuit de mesure de tension (B) est isolé galvaniquement de la connexion de tension capacitive.

6. Dispositif de commande/protection pour des réseaux de distribution d'énergie électrique selon la revendication 5, **caractérisé en ce qu'**il comprend un circuit de mesure de tension (B) indépendant pour chacune des phases de l'équipement électrique (4).

7. Dispositif de commande/protection pour des réseaux de distribution d'énergie électrique selon la revendication 1, **caractérisé en ce qu'**il comprend en plus des moyens de mesure d'intensité de l'équipement électrique (4).

8. Dispositif de commande/protection pour des réseaux de distribution d'énergie électrique selon la revendication 7, **caractérisé en ce que** les moyens de mesure d'intensité comprennent au moins un transformateur toroïdal ou dispositif de détection (5) installé sur l'extérieur à la base d'une douille de connexion (3) des câbles d'alimentation de l'équipement électrique (4).

9. Dispositif de commande/protection pour des réseaux de distribution d'énergie électrique selon la revendication 7, **caractérisé en ce que** les moyens de mesure d'intensité comprennent au moins un transformateur toroïdal ou dispositif de détection (5) agencé à l'intérieur d'une douille de connexion (3) des câbles d'alimentation de l'équipement électrique (4).

10. Dispositif de commande/protection pour des réseaux de distribution d'énergie électrique selon la revendication 9, **caractérisé en ce qu'**il comprend en plus des courbes de protection qui sont du même type que les courbes de protection de tête du réseau de distribution pour la détection de passage de défaut.

11. Dispositif de commande/protection pour des réseaux de distribution d'énergie électrique selon la revendication 7, **caractérisé en ce que** la mesure d'intensité, avec les mesures obtenues du circuit de mesure de tension (B) et du circuit d'indication ou de détection de présence/absence de tension (A), permet de déterminer le passage de défaut.

12. Dispositif de commande/protection pour des réseaux de distribution d'énergie électrique selon la revendication 7, **caractérisé en ce que** la mesure d'intensité, avec la mesure obtenue du circuit de mesure de tension (B), permet de déterminer la directionalité du passage de défaut.

13. Dispositif de commande/protection pour des réseaux de distribution d'énergie électrique selon la revendication 10, **caractérisé en ce que** la détection de passage de défaut permet de sectionner automatiquement des lignes.

14. Dispositif de commande/protection pour des réseaux de distribution d'énergie électrique selon la revendication 1, **caractérisé en ce qu'**il comprend en plus des moyens pour détecter la position du commutateur, du commutateur de sectionnement ou du commutateur de sectionnement de terre de l'équipement électrique (4) dans lequel il est installé.

15. Dispositif de commande/protection pour des réseaux de distribution d'énergie électrique selon la revendication 1, **caractérisé en ce qu'**il comprend en plus des moyens pour recevoir et/ou transmettre une commande de fonctionnement du commutateur, du commutateur de sectionnement, du commutateur de sectionnement de terre.

16. Dispositif de commande/protection pour des réseaux de distribution d'énergie électrique selon la revendication 1, **caractérisé en ce qu'**il comprend en plus des moyens pour recevoir des signaux de commande et de mesure concernant la température, la pression, le niveau de fluide, etc.

17. Dispositif de commande/protection pour des réseaux de distribution d'énergie électrique selon la revendication 1, **caractérisé en ce qu'**il comprend en plus des moyens d'enregistrement pour mémoriser les défauts détectés, ainsi que les différents paramètres de configuration.

18. Dispositif de commande/protection pour des réseaux de distribution d'énergie électrique selon la revendication 7, **caractérisé en ce que** le circuit d'indication ou de détection de présence/absence de tension (A) permet d'effectuer un verrouillage de prévention de mise à la terre empêchant la mise à la terre du commutateur (21) de l'équipement électrique (4) lorsque la tension est détectée dans la ligne.

19. Dispositif de commande/protection pour des réseaux de distribution d'énergie électrique selon la revendication 7, **caractérisé en ce que** le dispositif (14) permet la détection de défaut de terre pour chacune des phases.

20. Dispositif de commande/protection pour des réseaux de distribution d'énergie électrique selon la revendication 1, **caractérisé en ce qu'**il comprend en plus un transformateur toroïdal (22) englobant toutes les phases pour la détection de défaut de terre.

21. Dispositif de commande/protection pour des réseaux de distribution d'énergie électrique selon la revendication 19, **caractérisé en ce que** la détection de défaut de terre permet la détection de courants anormaux de moins de 10 % de l'intensité de phase nominale.

22. Dispositif de commande/protection pour des réseaux de distribution d'énergie électrique selon la revendication 1, **caractérisé en ce qu'**il comprend des moyens pour mesurer les valeurs de tension et d'intensité instantanées et des moyens pour calculer les valeurs d'intensité et de tension efficaces de chaque phase et des moyens pour déterminer les tensions et les intensités homopolaires, l'énergie, la puissance, etc.

23. Dispositif de commande/protection pour des réseaux de distribution d'énergie électrique selon la revendication 1, **caractérisé en ce qu'**il comprend en plus une série d'entrées et de sorties numériques permettant d'exécuter des applications de commande à distance des centres de transformation et de distribution, mettant en oeuvre la commande et la supervision de chaque équipement électrique (4).

24. Dispositif de commande/protection pour des réseaux de distribution d'énergie électrique selon la revendication 6, **caractérisé en ce que** la mesure de tension individualisée dans chacune des phases permet la détection d'une phase ouverte en n'importe quel point de la ligne.

25. Dispositif de commande/protection pour des réseaux de distribution d'énergie électrique selon l'une quelconque des revendications précédentes, **caractérisé en ce que** le dispositif de commande/protection est un dispositif triphasé.

26. Dispositif de commande/protection pour des réseaux de distribution d'énergie électrique selon l'une quelconque des revendications précédentes, **caractérisé en ce que** le dispositif de commande/protection est intégré dans l'équipement électrique (4).
